# EUROPEAN PATENT APPLICATION

(11) **EP 4 167 299 A1**
(43) Date of publication of application: **19.04.2023**
(21) Application number: 20951147.6
(22) Date of filing: 04.11.2020
(51) Int. Cl.: H01L 31/05

(54) **INTERCONNECTION PIECE AND SOLAR CELL ASSEMBLY**

(30) Priority: 31.08.2020 CN 202010901005
(71) Applicant: Longi Solar Technology (Taizhou) Co., Ltd., Taizhou, Jiangsu 225300 (CN)
(72) Inventor: LI, Hua, Taizhou, Jiangsu 225300 (CN); WANG, Yong, Taizhou, Jiangsu 225300 (CN); CHEN, Peng, Taizhou, Jiangsu 225300 (CN); ZHAO, Debao, Taizhou, Jiangsu 225300 (CN); CHEN, Jun, Taizhou, Jiangsu 225300 (CN); LIU, Jiyu, Taizhou, Jiangsu 225300 (CN)
(74) Representative: Loo, Chi Ching
(86) International application number: PCT/CN2020/126426
(87) International publication number: WO 2022/041479

(57) **Abstract**

An interconnection piece (200) and a solar cell assembly, which relate to the technical field of photovoltaics and which ensure the normal interconnection of cell pieces, while also inhibiting the degree of deformation of back contact cells during welding. The interconnection piece (200) includes a flexible insulation substrate (210) and a plurality of structural welding strips (220) that are spaced apart on the flexible insulation substrate (210). Each structural welding strip (220) is provided with two welding portions and a connecting portion (221) located between the two welding portions. The connecting portions (221) are connected to two welding portions, respectively. At least part of each connecting portion (221) is located in the flexible insulation substrate (210), and the two welding portions extend out of the flexible insulation substrate (210). The solar cell assembly includes the interconnection piece (200) mentioned above. The provided interconnection piece (200) is used to interconnect back contact cells.

## Description

### CROSS-REFERENCE TO RELEVANT APPLICATIONS

The present disclosure claims the priority of the Chinese patent application filed on August 31^{st}, 2020 before the CNIPA, China National Intellectual Property Administration with the application number of 202010901005.7 and the title of "INTERCONNECTION PIECE AND SOLAR CELL ASSEMBLY", which is incorporated herein in its entirety by reference.

### TECHNICAL FIELD

The present disclosure relates to the technical field of photovoltaics and, more particularly, to an interconnection piece and a solar cell assembly.

### BACKGROUND

Back-contact cell is a cell in which both an anode and a cathode of a solar cell are located on a back of the solar cell, and may be interconnected by using a solder strip. The back-contact cell not only completely eliminates light-shading losses of a front grid electrode, but also improves cell efficiency and makes the cell more beautiful.

However, since the anode and the cathode of the back-contact cell are both located on the back of the back-contact cell, a thermal expansion coefficient of the solder strip is quite different from that of a cell piece. Therefore, when the solder strip is soldered on a pad of the back-contact cell, heat released by soldering makes the solder strip expand, and after the soldering is finished, the solder strip shrinks due to temperature drop, which leads to serious bending deformation of the back-contact cell, thus affecting a soldering stability and increasing a risk of fragments and hidden cracks in an assembly process. Therefore, it is urgent to find an interconnection piece capable of replacing the solder strip to realize the back-contact cell, so as to reduce a deformation degree of the back-contact cell during soldering.

### SUMMARY

The present disclosure aims at providing an interconnection piece and a solar cell assembly, so that normal interconnection of cell pieces is ensured, and a deformation degree of a back-contact cell during soldering is inhibited a same time.

In a first aspect, the present disclosure provides an interconnection piece, including: a flexible insulating substrate and a plurality of structural solder strips arranged on the flexible insulating substrate at intervals. Each structural solder strip is provided with two soldering portions and a connecting portion located between the two soldering portions. The connecting portion is respectively connected to the two soldering portions. The two soldering portions extend out of the flexible insulating substrate, and at least a part of the connecting portion is located on the flexible insulating substrate.

With the foregoing technical solution, the plurality of structural solder strips are arranged on the flexible insulating substrate at intervals, at least a part of the connecting portion is located on the flexible insulating substrate, and the two soldering portions connected to the connecting portion extend out of the flexible insulating substrate. Based on this, when a stress is generated by the structural solder strip due to a soldering process, a laminating process and a difference between outdoor high and low temperatures, the connection portion contained in the structural solder strip may transfer the stress to the flexible insulating substrate and release the stress through the flexible insulating substrate, thus reducing a bending deformation degree of the back-contact cell and improving soldering stability and long-term use stability. Meanwhile, the flexible insulating substrate plays a role in fixing and dust prevention on the plurality of structural solder strips in the soldering process, preventing a relative position deviation between the structural solder strips and the pads in the soldering process and particles generated by soldering from migrating to a front of the cell piece, thereby improving a soldering accuracy.

In addition, when the interconnection piece provided by the present disclosure is applied to interconnection between the back-contact cells, the interconnection piece can not only be used as a vertical conducting channel to realize the interconnection between the back-contact cells, but also can provide electrical isolation for areas of two back-contact cells except the pads by means of the flexible insulating substrate, thereby reducing a possibility of electric leakage and improving cell efficiency.

In a probable implementation, the connecting portion of each structural solder strips is provided with a hollow structure for releasing stress. When the stress is generated by the structural solder strip due to the soldering process, the laminating process and the difference between the outdoor high and low temperatures, the connection portion can not only transfer the stress to the flexible insulating substrate, but also the hollow structure can release a part of the stress, thus further reducing the bending deformation degree of the back-contact cell and improving the soldering stability and the long-term use stability.

In a probable implementation, the above hollow structure includes at least one through hole. A pattern of each through hole is a closed pattern. At this time, the closed pattern here refers to that an outline pattern of the hollow structure is closed. In this case, an edge outline of the connecting portion is complete, which can ensure that the structural solder strip has good strength.

The pattern of each through hole is a polygonal pattern, a circular pattern, an elliptical pattern or a special-shaped pattern. The polygonal pattern may be a triangle, a rectangle, a square, or the like.

In a probable implementation, the above hollow structure includes m rows of through holes, and m is an integer greater than or equal to 1. Each row of through holes includes at least one through hole. The first row of through holes and the m-th row of through holes are formed in the connecting portion along any direction parallel to the connecting portion.

In a probable implementation, two adjacent rows of through holes are distributed in a staggered way. At this time, the m rows of through holes in the connecting portion can uniformly release the stress generated by the structural solder strips, and further reduce the deformation degree of the back-contact cell.

In a probable implementation, when the above-mentioned through holes are slit-type through holes or rectangular through holes, if a length direction of the through hole is from the distribution direction of the two soldering portions, then an interval between two rows of through holes may be adjusted, so that a current of one soldering portion can be transmitted to the other soldering portion through the connecting portion as linearly as possible, thereby reducing a current loss.

In a probable implementation, m is an integer greater than or equal to 3. A quantity of through holes included in the first row of through holes and a quantity of through holes in the m-th row of through holes are both greater than or equal to 2. In this case, along the distribution direction of the first row of through holes to the m-th row of through holes, a quantity of through holes included in each row of through holes first decreases and then increases.

With the foregoing technical solution, along the distribution direction of the first row of through holes to the m-th row of through holes, if the length of each row of through holes along the row direction decreases first and then increases, a structural strength of the connecting portion increases first and then decreases, and a stress of the connecting portion sequentially decreases first and then sequentially increases along the distribution direction of the first row of through holes to the m-th row of through holes. Based on this, a distribution manner of the through holes in the connecting portion may be used to adjust strength and a stress release capacity of each area of the connecting portion, so that the strength and the stress release capacity of the connecting portion achieve coordination.

In a probable implementation, when m is an integer greater than or equal to 3, the quantity of through holes included in the first row of through holes and the quantity of the m-th row of through holes are both greater than or equal to 1; along the distribution direction of the first row of through holes to the m-th row of through holes, the quantity of through holes included in each row of through holes first increases and then decreases.

With the foregoing technical solution, along the distribution direction of the first row of through holes to the m-th row of through holes, if the length of each row of through holes along the row direction decreases first and then increases, the structural strength of the connecting portion increases first and then decreases, and the stress of the connecting portion sequentially increases first and then sequentially decreases along the distribution direction of the first row of through holes to the m-th row of through holes. Based on this, a distribution manner of the through holes in the connecting portion may be used to adjust strength and a stress release capacity of each area of the connecting portion, so that the strength and the stress release capacity of the connecting portion achieve coordination.

In a probable implementation, central axes of the two soldering portions are collinear. In this case, a current flowing from one soldering portion to the other soldering portion may be conducted as nearly as straight as possible.

In a probable implementation, a width of each soldering portion is smaller than a maximum width of the connecting portion. Each soldering portion is connected to the connecting portion in an arc transition mode. When the arc transition mode is adopted, stress concentration at the arc transition is not easy to occur, thus further reducing the stress generated by the structural solder strip due to temperature change.

In a probable implementation, the flexible insulating substrate above is a light-shielding flexible insulating substrate. When the interconnection piece interconnects two adjacent back-contact cells, if the flexible insulating substrate is partially or completely located in a gap between the two adjacent back-contact cells, the flexible insulating substrate may be used as a visual shielding structure, so that the structural solder strip on the back of the solar cell assembly cannot be seen when viewed from the front of the solar cell assembly, thereby improving aesthetics of the solar cell assembly.

In a probable implementation, at least one surface of the flexible insulating substrate above is partially or completely provided with a shielding coating. A shielding effect of the shielding coating refers to the related description of the light-shielding flexible insulating substrate, which will not be elaborated here.

In a probable implementation, the flexible insulating substrate above is a single-sided adhesive tape provided with a release layer or a double-sided adhesive tape provided with a release layer.

With the foregoing technical solution, the flexible insulating substrate can be bonded with the back-contact cell, thus achieving a function of positioning the structural solder strips. In addition, when the interconnection piece is applied to the interconnection between the back-contact cells, if the flexible insulating substrate is located between two adjacent back-contact cells, the release layer of the single-sided adhesive tape or the double-sided adhesive tape can not only be used as a visual shielding layer to improve the aesthetics of the solar cell assembly, but also reduce particle pollution.

In a probable implementation, a surface of the connecting portion of each structural solder strip facing away from the flexible insulating substrate is exposed. In this case, each structural solder strip may be pressed to the flexible insulating substrate by pressing and other processes.

In a probable implementation, when the connecting portion of each structural solder strip is embedded in the flexible insulating substrate, at least a part of the connecting portion of each structural solder strip is wrapped in the flexible insulating substrate. In this case, the interconnection piece is a sandwich structure, and the flexible insulating substrate may be used to further fix the structural solder strip, which not only further reduces or eliminates possible displacement of the structural solder strip in the soldering process, but also eliminates a possibility of connection failure between the structural solder strip and the flexible insulating substrate when one soldering portion of the structural solder strip is stressed and warped, thus ensuring connection stability between the structural solder strip and the flexible insulating substrate.

In a probable implementation, a structure of the flexible insulating substrate above is a strip-shaped structure. The plurality of structural solder strips are distributed along a strip-shaped extension direction of the flexible insulating substrate at intervals.

In a probable implementation, each structural solder strip is thermally pressed or bonded on the flexible insulating substrate. When each structural solder strip is thermally pressed and bonded on the flexible insulating substrate, and each structural solder strip is bonded on the flexible insulating substrate, a binder may be a polymer binder, including but not limited to one or more of polyvinyl acetate, polyvinyl acetal, acrylate, polystyrene, epoxy resin, acrylic resin, polyurethane resin, unsaturated polyester, butyl rubber, nitrile rubber, phenolic-polyvinyl acetal and epoxy-polyamide.

In a probable implementation, the flexible insulating substrate above is internally provided with a conducting layer. The connecting portions of each structural solder strip are electrically connected through the conducting layer. The connecting portions of each structural solder strip are electrically connected through the conducting layer. The conducting layer may be a conducting ribbon or a conducting particle layer composed of metal particles in contact with each other.

With the foregoing technical solution, the conducting layer above can electrically connect the conducting layers contained in each structural solder strip together, so that the conducting layers may be used as transverse conducting channel. When one soldering portion contained in one structural solder strip in the plurality of structural solder strips has poor soldering with a corresponding polar pad, the structural solder strip is partially failed as a vertical conducting channel, but the structural solder strip can also conduct a current to other well-soldered structural solder strips by using the conducting layer, thus avoiding a problem of cell efficiency reduction when the vertical conductive channel is partially failed, thereby improving connection reliability of the interconnection piece.

In a second aspect, the present disclosure further provides a solar cell assembly, including at least two cell pieces and a plurality of interconnection pieces used for interconnecting the cell pieces, wherein each interconnection piece is the interconnection piece described in the first aspect or any item in the first aspect. A back of each cell piece is provided with two types of polar pads. Each polar pad contained in each type of polar pads is soldered with one soldering portion of the corresponding structural solder strip contained in the corresponding interconnection piece.

In a probable implementation, a gap is disposed between the two adjacent cell pieces. If the corresponding interconnection piece is contained in the gap, and a back of each cell piece is provided with two types of polar pads close to an edge of the cell piece, the different polar pads of the two adjacent cell pieces are close to the same gap, and the interconnection piece corresponding to the different polar pads of the two adjacent cell pieces is the same interconnection piece, so that the interconnection of the two adjacent cell pieces is implemented by using one interconnection piece.

In a probable implementation, the solar cell assembly above further includes at least one junction bar. Each junction bar is soldered with one soldering portion contained in the plurality of structural solder strips of the corresponding interconnection piece. In this case, the junction bar and the interconnection piece may collect and conduct a current generated by the cell pieces.

In a probable implementation, when the junction bar above is located between the two adjacent cell pieces, the interconnection pieces corresponding to different polar pads of the two adjacent cell pieces are different interconnection pieces, and the interconnection pieces corresponding to the different polar pads of the two adjacent cell pieces share one junction bar, so that the two adjacent cell pieces are soldered by using two interconnection pieces and one junction bar.

In a probable implementation, when the plurality of cell pieces are located on the same side of the junction bar, and the same polar pads of the plurality of cell pieces are close to the junction bar, the junction bar may be used to solder the soldering portions contained in the interconnection pieces corresponding to the same polar pads of these cell pieces on the junction bar, so that the plurality of cell pieces are connected in parallel by one junction bar.

In a probable implementation, the solar cell assembly above further includes a visual shielding layer located between the two adjacent cell pieces, and the visual shielding layer is located on a surface of at least one of the interconnection pieces facing a front of the cell piece. At this time, when the flexible insulating substrate included in the interconnection piece is transparent, the visual shielding layer may be used to shield the structural solder strip, so that an appearance of the solar cell assembly is beautiful.

In a probable implementation, the soldering portion above is soldered on the corresponding polar pad of the cell piece by electromagnetic or infrared soldering.

The beneficial effects of the second aspect or any probable implementation of the second aspect are the same as those of the first aspect or any probable implementation of the first aspect, and will not be repeated here.

The above description is merely a summary of the technical solutions of the present disclosure. In order to more clearly know the technical means of the present disclosure to enable the implementation according to the contents of the description, and in order to make the above and other objects, features and advantages of the present disclosure more apparent and understandable, the particular embodiments of the present disclosure are provided below.

### BRIEF DESCRIPTION OF THE DRAWINGS

In order to more clearly illustrate the technical solutions of the embodiments of the present disclosure or the prior art, the drawings that are required to describe the embodiments or the prior art will be briefly introduced below. Apparently, the drawings that are described below are embodiments of the present disclosure, and a person skilled in the art can obtain other drawings according to these drawings without paying creative work.

The accompanying drawings illustrated here serve to provide a further understanding of the present disclosure and constitute a part of the present disclosure, and the illustrative embodiments of the present disclosure and together with the description thereof serve to explain the present disclosure, and do not constitute inappropriate definition to the present disclosure. In the drawings:
FIG. 1 is a schematic structural diagram of a solar cell assembly provided by embodiments of the present disclosure;
FIG. 2A to FIG. 2C are schematic diagrams of soldering structures of different quantities of cell pieces and interconnection pieces in the embodiments of the present disclosure;
FIG. 3A and FIG. 3B are schematic diagrams showing two back structures of a cell piece in the embodiments of the present disclosure;
FIG. 4A to FIG. 4C are schematic diagrams showing three back structures of a cell string set provided by the embodiments of the present disclosure;
FIG. 4D is a schematic diagram of a front of the cell string set shown in FIG. 4C;
FIG. 5 is a schematic diagram showing a slice of the cell piece in an embodiment of the present disclosure;
FIG. 6 is a schematic diagram showing a basic structure of an interconnection piece provided by the embodiments of the present disclosure;
FIG. 7A and FIG. 7B are schematic diagrams of two types of basic structures of a structural solder strip in the embodiments of the present disclosure;
FIG. 8 is a schematic structural diagram of a flexible insulating substrate provided by the embodiments of the present disclosure;
FIG. 9A is a schematic structural diagram of an example interconnection piece in the embodiments of the present disclosure;
FIG. 9B is a schematic structural diagram of another example interconnection piece in the embodiments of the present disclosure;
FIG. 10A is a schematic structural diagram of yet another example interconnection piece in the embodiments of the present disclosure;
FIG. 10B is a sectional view of the interconnection piece shown in FIG. 10A in an A-A direction;
FIG. 10C is another sectional view of the interconnection piece shown in FIG. 10A in the A-A direction;
FIG. 11A to FIG. 13A are schematic diagrams showing three types of distributions of a plurality of rows of through holes distributed along a first direction in the embodiments of the present disclosure;
FIG. 11B to FIG. 13B are schematic diagrams showing three types of distributions of a plurality of rows of through holes distributed along a second direction in the embodiments of the present disclosure;
FIG. 14 is a schematic structural diagram of a manufacturing device for an interconnection piece provided by the embodiments of the present disclosure; and
FIG. 15 is a structured flow chart of a manufacturing method for an interconnection piece provided by the embodiments of the present disclosure.

### DETAILED DESCRIPTION OF THE EMBODIMENTS

In order to make the objects, the technical solutions and the advantages of the embodiments of the present disclosure clearer, the technical solutions of the embodiments of the present disclosure will be clearly and completely described below with reference to the drawings of the embodiments of the present disclosure. Apparently, the described embodiments are merely certain embodiments of the present disclosure, rather than all of the embodiments. All of the other embodiments that a person skilled in the art obtains on the basis of the embodiments of the present disclosure without paying creative work fall within the protection scope of the present disclosure.

To make the technical problems to be solved, the technical solutions, and beneficial effects of the present disclosure clearer, the following further describes some embodiments of the present disclosure in detail with reference to the accompanying drawings and embodiments. It should be understood that the specific embodiments described herein are merely illustrative of the present disclosure and are not intended to limit the present disclosure.

It should be noted that when an element is called to be "fixed on" or "arranged on" another element, it may be directly arranged on another element or indirectly arranged on another element. When an element is called to be "connected" to another element, it may be directly connected to another element or indirectly connected to another element.

Moreover, the terms "first" and "second" are only used for descriptive purposes, but cannot be understood as indicating or implying relative importance, or implicitly indicating the number of indicated technical features. Therefore, the features defined with "first" and "second" can explicitly or implicitly include one or more of the features. In the description of the present disclosure, the meaning of "a plurality of is two or more than two, unless otherwise specifically defined. The meaning of "several" is one or more, unless otherwise specifically defined.

In the description of the present disclosure, it should be understood that the orientation or position relationship indicated by such terms as "upper", "lower", "front", "rear", "left", "right", or the like, is based on the orientation or position relationship shown in the drawings, which is only used for convenience of description of the present disclosure and simplification of description instead of indicating or implying that the indicated device or element must have a specific orientation, and be constructed and operated in a specific orientation, and thus shall not be understood as a limitation to the present disclosure.

In the description of the present disclosure, it should be noted that unless expressly stipulated and defined otherwise, terms such as "installation", "connected" and "connection", or the like, should be understood broadly, for example, the connection may be fixed connection, or detachable connection or integral connection; may be mechanical connection, and may also be electrical connection; and may be direct connection, may also be indirect connection through an intermediate medium, and may also be internal communication of two elements or interaction relationship of two elements. The specific meaning of the above terms in the present disclosure may be understood in a specific case by those having ordinary skills in the art.

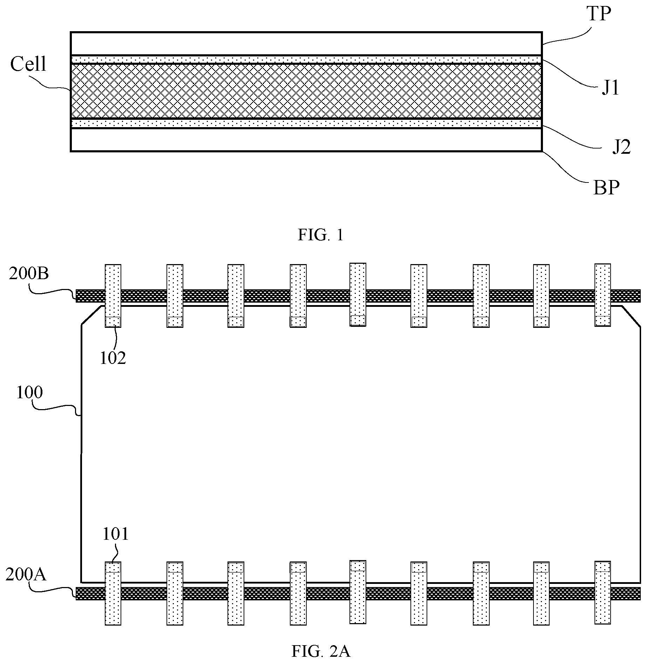

FIG. 1 is a schematic structural diagram of a solar cell assembly provided by the embodiments of the present disclosure. As shown in FIG 1, the solar cell assembly provided by the embodiments of the present disclosure may include a cell module Cell. In addition to the cell module Cell, the solar cell assembly may also include a package back plate BP, a package cover plate TP, and one or two common adhesive layers. For example, the cell module Cell is located between the package cover plate TP and the package back plate BP, a first adhesive layer J1 is disposed between the package cover plate TP and the cell module Cell, and a second adhesive layer J2 is disposed between the package back plate BP and the cell module Cell. As for the materials of adhesive layer, such as ethylene-vinyl acetate copolymer (EVA) are generally selected, but are not limited to this.

FIG. 2A to FIG. 2C show schematic diagrams of soldering structures of different quantities of cell pieces and interconnection pieces in the embodiments of the present disclosure. As shown in FIG. 2A to FGI. 2C, the cell module Cell shown in FIG. 1 includes at least two cell pieces 100 and a plurality of interconnection pieces 200 used for interconnecting the cell pieces 100. These cell pieces 100 and the interconnection pieces 200 may form the cell module Cell shown in FIG. 1.

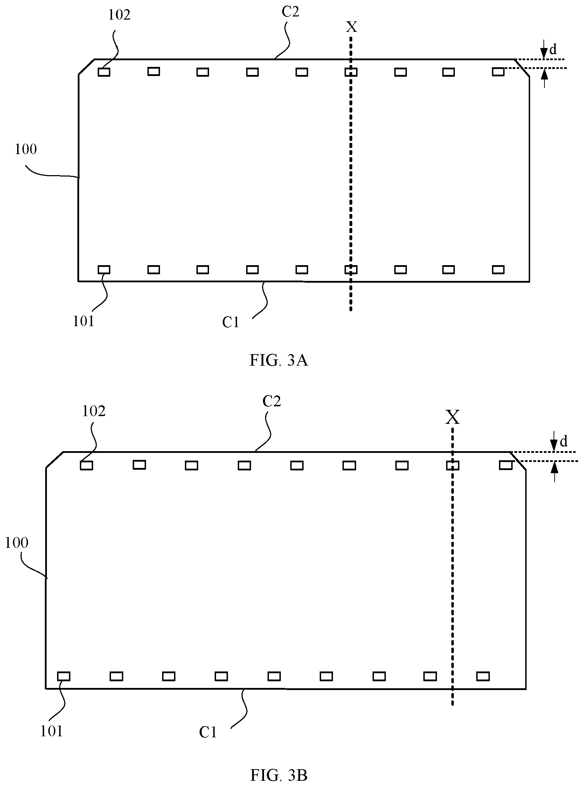

FIG. 3A and FIG. 3B are schematic diagrams showing two types of back structures of a cell piece in the embodiments of the present disclosure. As shown in FIG. 3A and FIG. 3B, when each cell piece 100 above is a back-contact cell, a front of each cell piece 100 may not be shielded by any grid, or there may be some fine grids, and a back of each cell piece 100 has a busbar, which can lead out holes and electrons. Based on this, as for the category of the cell piece 100, the cell piece may be an interdigitated back contact (IBC cell), a metallization wrap-through (MWT) silicon solar cell, an emitter-wrap-through (EWT) silicon solar cell, or the like, but not limited to this.

As shown in FIG. 3A and FIG. 3B, in order to lead out the holes and the electrons at the same time on the back of the cell piece 100, the back of the cell piece 100 is provided with two types of polar pads, namely, a first polar pad 101 and a second polar pad 102. When the first polar pad 101 is a cathode pad, the second polar pad 102 is an anode pad. When the first polar pad 101 is an anode pad, the second polar pad 102 is a cathode pad. During actual application, the back of each cell piece 100 is provided with a cathode polarity area such as a P-type area and an anode polarity area such as an N-type area. The cathode polarity area may be used for leading out the holes, and the cathode pad may be formed in the cathode polarity area. The anode polarity area may be used for leading out the electrons, and the anode pad is formed in the anode polarity area.

As shown in FIG. 3A and FIG. 3B, in order to reduce an influence of a stress generated by alternate cooling and heating (soldering process or external environment) of the interconnection piece 200 on the cell pipe 100, the two types of polar pads contained in the same cell piece 100 are close to an edge of the cell piece 100. Specifically, the cell piece 100 is provided with a first side edge C1 and a second side edge C2. The first polar pad 101 is formed on the back of the cell piece 100 in a way of being close to the first side edge C1, and the second polar pad 102 is formed on the back of the cell piece 100 in a way of being close to the second side edge C2. As long as the first side edge C1 and the second side edge C2 are located in different directions, they may be arranged oppositely or in an intersecting manner.

For example, as shown in FIG. 3A and FIG. 3B, the first side edge C1 and the second side edge C2 are arranged oppositely. The first side edge C1 may be one long side of the cell piece 100, and the second side edge C2 may be the other long side of the cell piece 100.

As shown in FIG. 3A and FIG. 3B, for the same cell piece 100, a quantity of the first polar pad 101 and a quantity of the second polar pad 102 may be one or more. When the quantity of the first polar pad 101 and the quantity of the second polar pads 102 are more, each first polar pad 101 and the corresponding second polar pad 102 may be collinear (collinear with respect to a dotted line X) as shown in FIG. 3A or staggered (staggered with respect to a dotted line x) as shown in FIG. 3B.

As shown in FIG. 3A and FIG. 3B, a minimum distance d between each type of polar pad and the edge of the cell piece may be 0 mm to 10 mm. FIG. 3A and FIG. 3B shows a minimum distance d between the second polar pad and the second side edge. When d is equal to 0 mm, one side of the second polar pad 102 close to the edge of the cell piece is flush with the second side edge C2. When d is greater than 0, and equal to or less than 10 mm, a gap (with a width of d) is disposed between one side of the second polar pad 102 close to the edge of the cell piece and the second cell piece edge C2, which can reduce an influence of a stress generated in the soldering process on the edge of the cell piece.

Each type of polar pad may be soldered with the corresponding interconnection piece. It is defined herein that the interconnection piece soldered with each type of polar pad is the interconnection piece corresponding to this type of polar pad. Soldering methods include but are not limited to electromagnetic or infrared soldering. A shape of each type of polar pad may be rectangular, circular, elliptical or other shapes, which may be selected according to the actual situation. As for a size of each polar pad, it may be 0.5 mm to 5 mm (a maximum radial size of the pad. For example, when the cathode pad is a circular pad, a maximum radial size of the circular pad is a diameter of the circular pad. For another example, the cathode pad is an elliptical pad, a maximum radial size of the elliptical pad is a major axis of the elliptical pad), so that each type of polar pad has an enough soldering area for being soldered with the corresponding interconnection piece. When soldering the polar pad with the corresponding interconnection piece, the interconnection piece may be soldered on the corresponding polar pad by electromagnetic or infrared soldering. For example, when the polar pad is soldered with the corresponding interconnection piece by electromagnetic soldering, the soldering is carried out at a temperature of 180°C to 380°C and lasts for 1,000 ms to 4,000 ms.

In one example, as shown in FIG. 2A, for the same interconnection piece 200, the interconnection piece 200 soldered with the first polar pad 101 is defined as a first interconnection piece 200A corresponding to the first polar pad 101, and the interconnection piece 200 soldered with the second polar pad 102 is defined as a second interconnection piece 200B corresponding to the second polar pad 102.

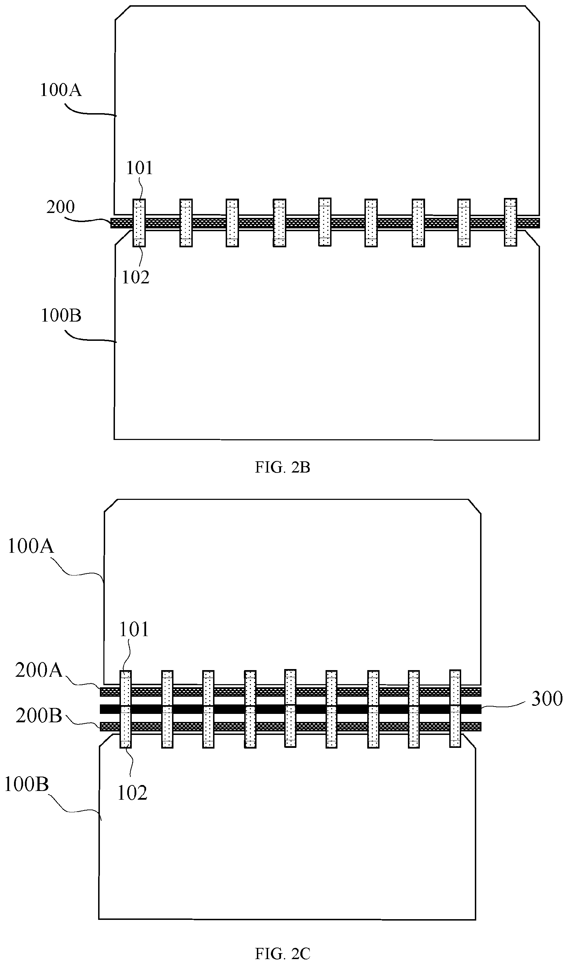

In another example, as shown in FIG. 2B and FIG. 2C, for two adjacent cell pieces, the cell pieces corresponding to different polar pads of the two adjacent cell pieces may be the same interconnection piece 200 or different interconnection pieces 200. The two adjacent cells may be defined as a first cell piece 100A and a second cell piece 100B. A gap is disposed between the first cell piece 100A and the second cell piece 100B. the corresponding interconnection piece 200 (i.e., the interconnection piece 200 corresponding to the gap between the first cell piece 100A and the second cell piece 100B) is contained in the gap.

As shown in FIG. 2B and FIG. 2C, when the first polar pad 101 on a back of the first cell piece 100A and the second polar pad 102 on a back of the second cell piece 100B are both close to the edge of the cell piece, and the different polar pads of the first cell piece 100A and the second cell piece 100B are close to the same gap. In practical application, when the first polar pad 101 contained in the first cell piece 100A and the second polar pad 102 contained in the second cell piece 100B are arranged opposite to each other, the first polar pad 101 of the first cell piece 100A and the second polar pad 102 of the second cell piece 100B are close to the gap between the first cell piece 100A and the second cell piece 100B.

When the cell piece corresponding to different polar pads of the two adjacent cell pieces are the same interconnection piece, as shown in FIG. 2B, the first polar pad 101 of the first cell piece 100A and the second polar pad 102 of the second cell piece 100B are soldered by the same interconnection piece 200. At this time, the interconnection between the first polar pad 101 of the first cell piece 100A and the second polar pad 102 of the second cell piece 100B is realized by using the same interconnection piece 200.

When the cell pieces corresponding to different polar pads of the two adjacent cell pieces are different interconnection pieces, as shown in FIG. 2C, the interconnection piece corresponding to the first polar pad 101 of the first cell piece 100A is the first interconnection piece 200A, and the interconnection piece corresponding to the second polar pad 102 of the second cell piece 100B is the second interconnection piece 200B, and one end of the first interconnection piece 200A away from the first cell piece 100A and one end of the second interconnection piece 200B away from the second cell piece 100B are both soldered on a junction bar 300. In this case, the first interconnection piece 200A and the second interconnection piece 200B share one junction bar 300, and the first interconnection piece 200A, the junction bar 300 and the second interconnection piece 200A may form an interconnection assembly to connect the first cell piece 100A and the second cell piece 100B in series.

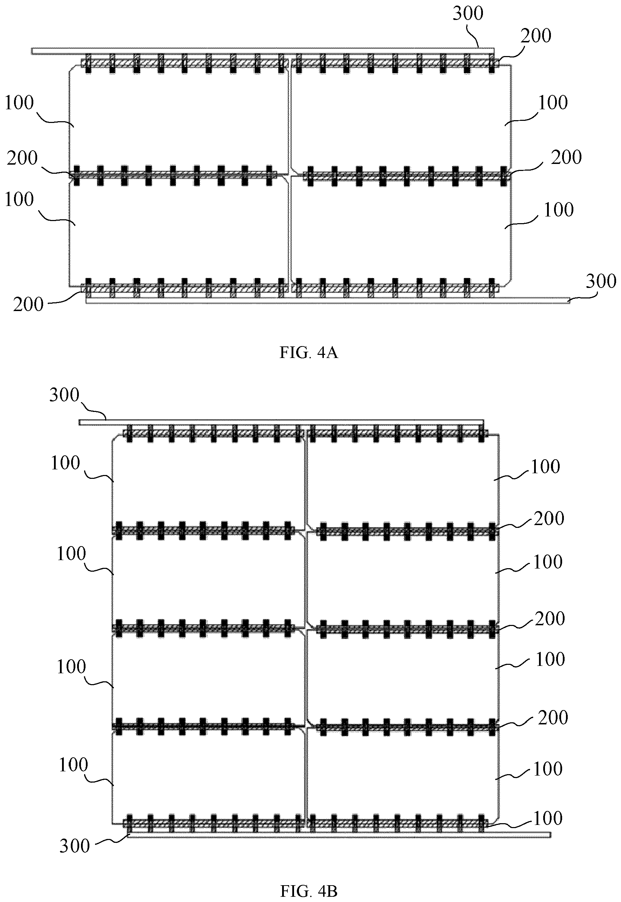

FIG. 4A to FIG. 4C are schematic diagrams showing three back structures of a cell string set provided by the embodiments of the present disclosure. As shown in FIG. 4A to FIG. 4C, the solar cell assembly above may also include at least one junction bar 300. Each junction bar 300 may be soldered with the corresponding interconnection piece 200 to realize the interconnection of the cell pieces 100. In practical application, the junction bar 300 may be soldered with the corresponding interconnection piece 200 in advance, and then one end of the interconnection piece 200 away from the junction bar 300 may be soldered on the corresponding polar pad, or one end of the interconnection piece 200 may be soldered the corresponding polar pad, and then the junction bar 300 is soldered on end of the interconnection piece 200 away from the corresponding polar pad.

In an example, as shown in FIG. 4A, firstly, every two cells may be soldered together to form a cell string, and then two cell strings may be connected in parallel by using the junction bar 300 to form a cell string set. For example, in two rows and two columns of half cells (four cells in total), two cell pieces 100 contained in each column of cell pieces are connected in series by the interconnection piece 200 to form a cell string, and then two cell strings are connected in parallel by using the junction bar 300 to form a cell string set as shown in FIG. 4A.

In another example, as shown in FIG. 4B, firstly, four cells may be soldered together as one set to form a cell string, and then the cell strings may be connected in parallel by using the junction bar 300 to form a cell string set. For example, in four rows and two columns of half cells (eight cells in total), every two cell pieces 100 contained in each column of cell pieces are connected in series by the interconnection piece 200 to form a cell string, and then two cell strings are connected in parallel by using the junction bar 300 to form a cell string set as shown in FIG. 4B.

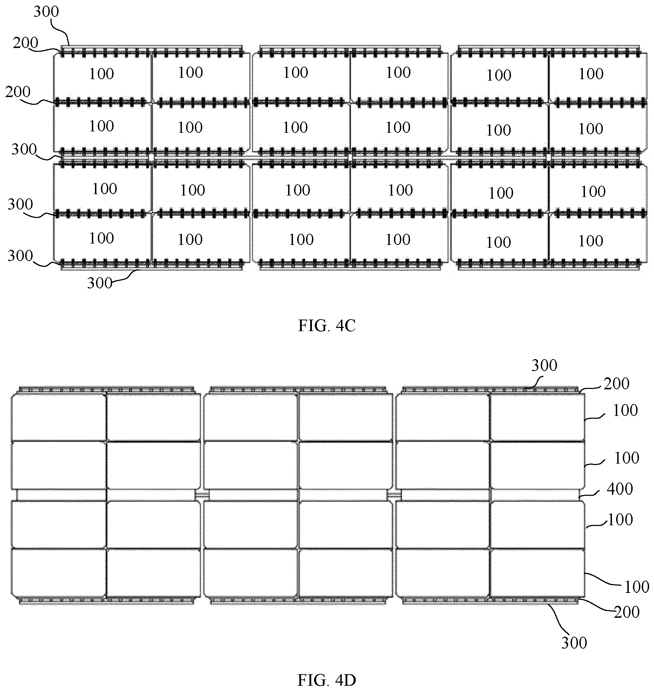

In another example, as shown in FIG. 4C, two cell pieces 100 may be connected in series as one set to form a cell string, and then the cell strings are connected in serial-parallel to form a cell string set. For example, in four rows and six columns of half cells (24 cells in total), firstly, two cell pieces 100 contained in each column of cell pieces 100 are connected in series as one set by using the interconnection piece 200 to form one cell string, and then 12 cell strings are interconnected by using two interconnection bars and the junction bar 300 connecting the two interconnection bars to form a cell string set as shown in FIG. 4C.

As shown in FIG. 4C, when the two adjacent cell pieces 100 are interconnected by the interconnection piece 200 above, a gap is disposed between the two adjacent cell pieces 200. The corresponding interconnection piece 200 is contained in the gap. In order to improve a visual effect of the assembly, FIG. 4D illustrates a front schematic diagram of the cell string set shown in FIG. 4C. As shown in FIG. 4D, the solar cell assembly above further includes a visual shielding layer 400 located between the two adjacent cell pieces 100. The visual shielding layer 400 is located on a surface of at least one of the interconnection pieces 200 facing a front of the cell piece. At this time, the visual shielding layer 400 may scatter sunlight irradiated on the visual shielding layer to the surrounding cell piece, so as to improve a light utilization rate of the cell piece. In addition, the adhesive layer (the second adhesive layer J2 shown in FIG. 1) used in the solar cell assembly is a polymeric material which is easy to age and discolor. For example, EVA is easy to turn brown when contacting with Cu or other materials for a long time. The visual shielding layer 400 can effectively reduce an influence of EVA discoloring on the appearance of the solar cell assembly.

In the actual assembling process, as shown in FIG. 4D, the visual shielding layer 400 may be attached to the interconnection piece 200 at first, and then the interconnection piece 200 and the corresponding polar pad are soldered together, so that the visual shielding layer 400 faces the front of the cell piece 100, so as to achieve the object of shielding the interconnection piece and ensure the good appearance of the solar cell assembly. For example, a material of the visual shielding layer 400 may be a light shielding material, and a color of the visual shielding layer may be close to or the same as that of the back plate of the solar cell assembly. For example, when a white back plate is used, the color of the visual shielding layer used is white, and when a black back plate is used, the color of the visual shielding layer is black.

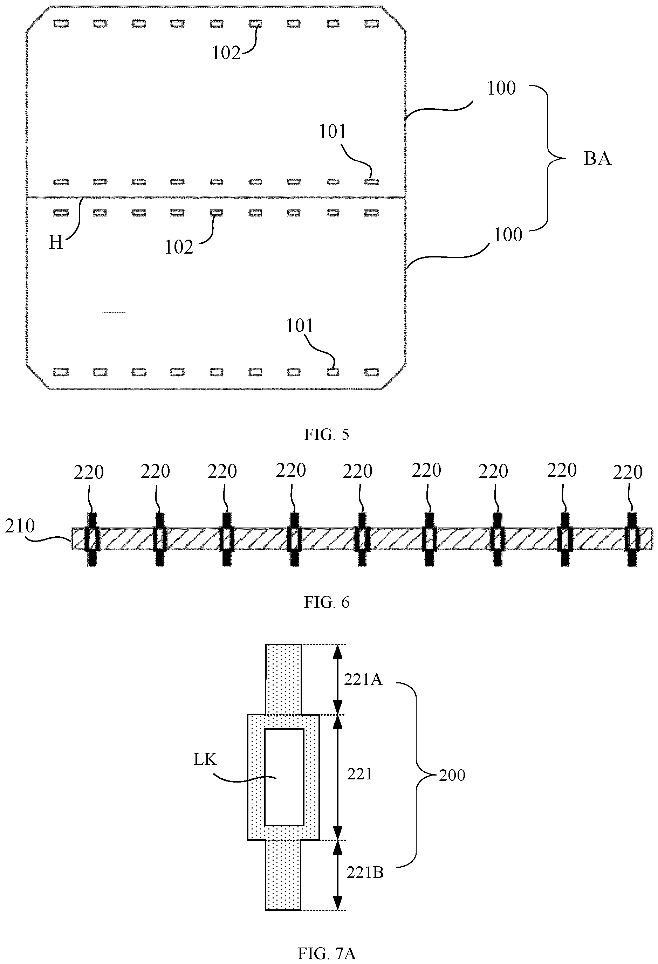

The cell piece 100 shown in FIG. 4A to FIG. 4C may be a complete cell piece BA shown in FIG. 5 or a sliced cell piece. FIG. 5 illustrates a schematic diagram showing a slice of the cell piece in the embodiments of the present disclosure. As shown in FIG. 5, these sliced cell pieces may be cut from a complete cell piece BA, and a cutting process may be implemented by using the existing cutting process. The sliced cell piece is 1/N sliced cell piece, and N is a quantity of cell pieces formed by cutting one complete cell BA. For example, a slice cutting path H is formed on the complete cell piece BA and the complete cell piece is cut along the slice cutting path H, which may form two cell pieces 100 defined as half cell pieces. Certainly, the complete cell piece BA may also be cut into more sub-cells with substantially equal area, which will not be described here.

When the interconnection piece 200 shown in FIG. 4A to FIG. 4C are used to interconnect the sliced cell pieces to form a solar cell assembly, the cell pieces in the solar cell assembly are usually interconnected by using a series-parallel structure, so as to ensure that the current of each busbar is reduced to 1/2 of the original, and the internal loss is reduced to 1/4 of the whole cell, so as to improve the power of the assembly. However, the reduction of the cell area here can reduce a resistance loss of interconnection and improve energy output efficiency, but may have multiple cutting damages, which may adversely affect performances of the cell. Therefore, it is necessary to decide the cutting and series connection design after comprehensive balance. For example, when a plurality of sliced cell pieces are connected in series and parallel, a solar photovoltaic assembly is enabled to have a higher output voltage, and more cell pieces can be connected in series. As for a quantity of the cell pieces, it is not limited, but depends on the actual demand.

In an example, a back of the cell piece may be designed as a Multi Bus Bar (MBB) structure. The MBB design can shorten a conduction distance of current on a fine grid, shorten a current collection path of the cell by more than 50%, reduce a loss of lateral resistance, and reduces a packaging loss, so that the assembly has high efficiency.

A quantity of the busbars of the MBB mainly depends on the balance of electricity and optics. Increasing the quantity of the busbars can reduce the series resistance, but increase a shading area correspondingly. Based on this, a quantity of each type of polar pads may be 6 BB to15 BB. The pad may be rectangular in shape, and has a size preferably as 2 mm×3 mm. A minimum distance between each type of polar pads and an edge of a corresponding cell piece may be 3 mm, so as to prevent cell piece cracking caused by excessive stress.

In order to improve the efficiency of the cell, a thinner busbar may be used for MBB design and small cell design. For example, the above cell piece may be a rectangular half IBC cell of 9 BB. In this case, a back of the IBC cell has two opposite long sides (i.e., the first side edge and the second side edge opposite to each other as previously mentioned). Nine first polar pads are spaced along a length direction and close to one long side, and nine second polar pads are spaced along the length direction and close to the other long side. Compared with other grid lines, the half IBC cell of 9 BB has the advantages of higher efficiency and lower difficulty in soldering process.

In order to realize the interconnection of the back-contact cell, the embodiments of the present disclosure provide an interconnection piece, which can relieve a stress caused by a soldering process and a difference between outdoor high and low temperatures, thereby reducing a bending deformation degree of the back-contact cell and improving soldering stability and accuracy.

FIG. 6 illustrates a schematic diagram of a basic structure of the interconnection piece provided by the embodiments of the present disclosure. As shown in FIG. 6, the interconnection piece provided by the embodiments of the present disclosure includes: a flexible insulating substrate 210 and a plurality of structural solder strips 220 formed on the flexible insulating substrate 210.

As shown in FIG. 6, the plurality of structural solder strips 220 may be arranged on the flexible insulating substrate 210 at intervals. A structure of the flexible insulating substrate 210 may be a strip-shaped structure, such that the plurality of structural solder strips 220 are distributed at intervals along a strip-shaped extension direction of the flexible insulating substrate 210.

When a certain polar pad of the cell piece is soldered with a corresponding interconnection piece, a quantity of corresponding polar pads of the interconnection piece is related to a quantity of structural solder strip contained in the interconnection piece. For example, a quantity of the first polar pads 101 and a quantity of second polar pads 102 of the cell piece shown in FIG. 4A are both 9, the quantity of the structural solder strips 220 disposed on the flexible insulating substrate 210 may be 9, or may be less than 9 or more than 9, so as to meet different circuit design requirements. Based on this, when a certain polar pad of the cell piece is soldered with a corresponding interconnection piece, each type of polar pads contained in the cell piece is soldered with the corresponding structural solder strip contained in the corresponding interconnection piece.

Compared with a traditional interconnection solder strip, the plurality of structural solder strips 220 shown in FIG. 6 are arranged on the flexible insulating substrate 210 at intervals, which can reduce a usage amount of solder strip materials, not only reduce a manufacturing cost, but also reduce a contact area between the structural solder strips 220 contained in the interconnection piece and the back of the cell piece, reduce an influence of a thermal stress during interconnection, and improve reliability of the solar cell assembly. More importantly, when the plurality of structural solder strips 220 may be arranged on the flexible insulating substrate 210 at intervals, the formed interconnection piece has good flexibility. Therefore, the structural solder strips 220 can release a thermal stress caused by the difference between high temperature and low temperature (such as soldering process, laminating process and outdoor environment change) through the flexible insulating substrate 210, thereby reducing the bending deformation degree of the back-contact cell and improving the soldering stability and long-term use stability. Meanwhile, when the interconnection piece provided by the embodiments of the present disclosure is applied to the interconnection between back-contact cells, the flexible insulating substrate 210 contained in the interconnection piece may provide electrical isolation for areas of two adjacent back-contact cells except the pads, thereby reducing a possibility of electric leakage and improving the cell efficiency. That is, the flexible insulating substrate 210 can prevent the structural solder strip 220 from forming a shunt path with an area where the cell piece does not need to be interconnected, thereby improving conversion efficiency of the cell.

Moreover, as shown in FIG. 6, during the soldering process between the interconnection piece and the corresponding polar pad, the flexible insulating substrate 210 can fix the plurality of structural solder strips 220 during the soldering process, so as to prevent the relative position deviation between the structural solder strip 220 and the pad during the soldering process, thereby improving soldering accuracy and avoiding an electrical short circuit when the structural solder strips 220 and the pad are misaligned. Moreover, as shown in FIG. 2A to FIG. 2D, when the interconnection piece 200 is located in a gap between two adjacent cells or on one side of a cell piece, the flexible insulating substrate 210 shown in FIG. 6 may be partially or completely located in the gap or on one side of the cell piece. If the flexible insulating substrate 210 is partially located in the gap or on one side of the cell piece, the area of the flexible insulating substrate 210 that is not located in the gap or on one side of the cell piece may be attached to an edge of the cell.

When the interconnection piece is located in the gap between two adjacent cell pieces or on one side of the cell piece, the flexible insulating substrate 210 shown in FIG. 6 may block the gap at the edge of the cell piece, and reduce the possibility of particles generated in the soldering process migrating to a front of the cell piece through the edge of the cell, so as to reduce the pollution of particles to the front of the cell piece during the soldering process, subsequent process or use process. Moreover, the flexible insulating substrate 210 may also be used as an interval mark of the back-contact cell, thus realizing assembly symmetry and aesthetics of the solar cell assembly.

In an optional way, as shown in FIG. 6, the structural solder strip 220 may be formed by a stamping process, a chemical etching process, an electrospark machining process, a laser cutting process or other suitable manufacturing processes. The plurality of structural solder strips 220 are arranged on the flexible insulating substrate at intervals, which not only can manufacture the interconnection piece with excellent strain relief ability, but also have a relatively low manufacturing cost. The original solder strip for manufacturing the structural solder strip may have a thickness of 0.02 mm to 0.3 mm, and a width of 3 mm to 7 mm. For example, the original solder strip is made of copper-based materials such as oxygen-free copper or T2 red copper, with a copper content greater than or equal to 99.99wt% and an electrical conductivity greater than or equal to 98%. The solder strip is a double-sided coating made of Sn63Pb37 with a coating thickness of 0.02 mm to 0.1 mm, and a melting point of the coating is about 183°C. The solder strip has a tensile strength greater than or equal to150 N/mm², an elongation at break greater than or equal to 20%, and a yield stress less than or equal to 65 MPa.

As shown in FIG. 6, each structural solder strip 220 may be formed on the flexible insulating substrate 210 by using thermal pressing or bonding, so that the structural solder strip 220 and the flexible insulating substrate 210 form an integral interconnection piece. When each structural solder strip 220 is formed on the flexible insulating substrate 210 in an adhesive manner, the flexible insulating substrate 210 may be an insulating polymer material. The polymer material includes one or more of polyvinyl butyral (PVB), polyolefin (POE) and ethylene-vinyl acetate copolymer (EVA), but is not limited to this. The binder may be a polymer binder, including but not limited to one or more of polyvinyl acetate, polyvinyl acetal, acrylate, polystyrene, epoxy resin, acrylic resin, polyurethane resin, unsaturated polyester, butyl rubber, nitrile rubber, phenolic-polyvinyl acetal, epoxy-polyamide, but not limited to this.

In an example, as shown in FIG. 6, when a gap is disposed between two adjacent cell pieces and the interconnection piece is contained in the gap, the flexible insulating substrate 210 contained in the interconnection piece may be a light-shielding flexible insulating substrate or a transparent flexible insulating substrate. When the flexible insulating substrate 210 contained in the interconnection piece is a light-shielding flexible insulating substrate, because the flexible insulating substrate 210 is partially or completely located in the gap between the two adjacent back-contact cells, the flexible insulating substrate 210 may be used as a visual shielding structure, such that the structural solder strip 220 on the back of the solar cell assembly will not be seen when viewed from the front of the solar cell assembly, thus improving the aesthetics of the solar cell assembly.

As shown in FIG. 6, when the flexible insulating substrate 210 is a light-shielding flexible insulating substrate, especially a transparent flexible insulating substrate, in order to improve a visual effect, on one hand, the aforementioned visual shielding layer may be attached to a surface of the flexible insulating substrate 210 that needs to face the front of the cell piece to shield the structural solder strip 220. On the other hand, the flexible insulating substrate 210 may be improved.

For example, the surface of the flexible insulating substrate above is partially or completely provided with a shielding coating. The shielding coating may be located on one side or both sides of the flexible insulating substrate, such that the flexible insulating substrate has an excellent light-shading effect. A color of the shielding coating may refer to a color of the aforementioned visual shielding layer, and an effect of the shielding coating may also refer to the related description of the aforementioned visual shielding layer.

For another example, the flexible insulating substrate above has a single-sided adhesive tape with a release layer or a double-sided adhesive tape provided with a release layer. The release layer can reduce pollution of an environment or an operating platform to a surface of the adhesive tape during the machining process of the solar cell assembly.

In an application scene, as shown in FIG. 4A to FIG. 4D and FIG. 6, when the above-mentioned interconnection piece is soldered on a corresponding polar pad, if the flexible insulating substrate 210 is located between two adjacent cell pieces100, the surface of the flexible insulating substrate 210 facing the front of the cell piece may have a release layer. A color of the release layer may refer to a color of the aforementioned visual shielding layer, and an effect of the release layer may also refer to the related description of the aforementioned visual shielding layer. Meanwhile, at the back of the flexible insulating substrate 210 facing the cell piece (that is, the surface on which the plurality of structural solder strips 220 are formed), the flexible insulating substrate 210 is located in an area between two adjacent structural solder strips 220, and a release layer may also be formed to prevent particle pollution (from component machining or subsequent use).

In an application scene, the adhesive side of the single-sided adhesive tape may be attached to edges of the two adjacent cell pieces close to the same gap, so that the adhesive side of the single-sided adhesive tape faces the front of the cell piece, and then the structural solder strip is soldered on the corresponding polar pad. In this case, the single-sided adhesive tape, as the flexible insulating substrate, plays a role in positioning before soldering, so that a position of the structural solder strip is not easy to displace when soldering the structural solder strip. Certainly, for the double-sided adhesive tape, it is only required to attach any side to the edges of the two adjacent cell pieces close to the same gap, which will not be elaborated here.

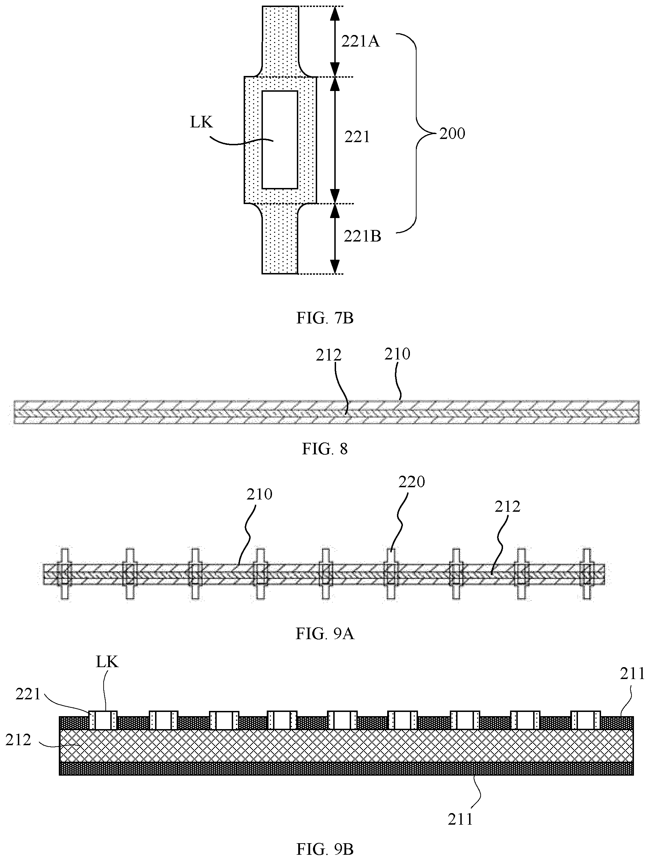

FIG. 7A and FIG. 7B illustrate schematic diagrams of two basic structures of the structural solder strip provided by the embodiments of the present disclosure. As shown in FIG. 7A and FIG. 7B, each structural solder strip 220 is provided with two soldering portions and a connecting portion 221 located between the two soldering portions. The connecting portion 221 is connected to the two soldering portions respectively. At least a part of the connecting portion 221 is located in the flexible insulating substrate 210. The two soldering portions extend out of the flexible insulating substrate. For example, each soldering portion may be a solid plane, and the two soldering portions may extend out of the flexible insulating substrate 210 in opposite directions.

When each type of polar pads of the cell piece is soldered with the structural solder strip corresponding to the corresponding interconnection piece, each polarity solder strip contained in each type of polarity solder strips is soldered with one soldering portion of each structural solder strip contained in the interconnection piece. The soldering methods include, but are not limited to, electromagnetic or infrared soldering on the corresponding polar pad of the cell piece. In addition, in the process of soldering, laminating or subsequent use, if a thermal stress is generated at the soldering portion, the thermal stress may be transferred to the flexible insulating substrate through the connecting portion, and a flexible action of the flexible insulating substrate may be used to release the thermal stress, thereby reducing the bending deformation degree of the back-contact cell and improving the soldering stability and long-term use stability.

Specifically, as shown in FIG. 7A and FIG. 7B, the two soldering portions above include a first soldering portion 221A and a second soldering portion 221B. The first soldering portion 221A and the second soldering portion 221B are both used for being soldered with a corresponding polar pad. For example, when the first soldering portion 221A is soldered with the first polar pad, the second soldering portion 221A is used to lead out the current, and may be soldered with a junction bar or a second polar pad of another cell piece.

As shown in FIG. 6, FIG. 7A and FIG. 7B, when each structural solder strip 220 is formed on the flexible insulating substrate 210 by hot pressing, a thickness of the flexible insulating substrate 210 is as thin as possible, for example, the thickness of the flexible insulating substrate 210 is less than 0.02 mm, so that bending degrees of the first soldering portion 221A and the second soldering portion 221B can be reduced, so that the first soldering portion 221A and the second soldering portion 221B are soldered to the corresponding polar pads as horizontally as possible, thus improving the soldering reliability. Certainly, the selected flexible insulating substrate 210 has thermoplasticity, in the laminating process, the flexible insulating substrate 210 may extend to a certain extent in an laminating thermal field environment, so that the flexible insulating substrate 210 may be filled between two adjacent cell pieces, thus completely shielding the gap between the two adjacent cell pieces, but the flexible insulating substrate may not extend to the back area of the cell piece to affect power generation of the cell piece. In addition, a thickness of the structural solder strip 220 is less than or equal to 1/3 of the thickness of the flexible insulating substrate 210, so as to avoid the problem that the structural solder strip 220 cuts off the flexible insulating substrate 210 due to an excessive hot pressing pressure in the hot pressing process. Based on this, the original solder strip may have a thickness of 0.12 mm, and a width of 5 mm preferably.

In an example, as shown in FIG. 7A and FIG. 7B, central axes of the first soldering portion 221A and the second soldering portion 221B are collinear. Here, when it is defined that the first soldering portion 221A and the second soldering portion 221B are rectangular, the axes of the first soldering portion 221A and the second soldering portion 221B along a length direction thereof are the central axes. In this case, a current flowing from the first soldering portion 221A to the second soldering portion 221B may be conducted as nearly as straight as possible.

In an example, as shown in FIG. 7A and FIG. 7B, a width of the first soldering portion 221A and a width of the second soldering portion 221B may both be less than a maximum width of the connecting portion 221. For example, when the first soldering portion 221A, the second soldering portion 221B and the connecting portion 221 are all rectangular structures, sizes of the first soldering portion 221A and the second soldering portion 221B may be 6 mm×1 mm, and a size of the connecting portion 221 may be 6 mmx3 mm. In this case, the widths of the first soldering portion 221A and the second soldering portion 221B are both 1 mm, and the width of the connecting portion 221 is 3 mm.

In an example, the first soldering portion 221A and the second soldering portion 221B as shown in FIG. 7A and FIG. 7B are connected to the connecting portion 221 by using a right-angle transition mode as shown in FIG. 7A or an arc transition mode as shown in FIG. 7B. When the arc transition mode as shown in FIG. 7B is adopted for connecting, stress concentration at the arc transition part is not easy to occur, thus further reducing the stress generated by the structural solder strip 220 caused by temperature change (soldering temperature change or external environment temperature change).

As shown in FIG. 2A, FIG. 7A and FIG. 7B, for the same cell piece, the first soldering portion 221A contained in the first interconnection piece 200A is soldered with the first polar pad 101 of the cell piece 100, and the second soldering portion 221B contained in the second interconnection piece 200B is soldered with the second polar pad 102 of the cell piece 100.

For two adjacent cell pieces, if the cell piece corresponding to different polar pads of the two adjacent cell pieces are the same interconnection piece, as shown in FIG. 2B, FIG. 7A and FIG. 7B, the first soldering portion 221A of each structural solder strip contained in the same interconnection piece 200 is soldered with each first polar pad 101 of the first cell piece 100A in one-to-one correspondence, and the second soldering portion 221B of each structural solder strip contained in the same interconnection piece 200 is soldered with each second polar pad 102 of the second cell piece 100B in one-to-one correspondence. When the cell pieces corresponding to the different polar pads of the two adjacent cell pieces are different interconnection pieces, as shown in FIG. 2C, FIG. 7A and FIG. 7B, the first soldering portion 221A of each structural solder strip contained in the first interconnection piece 200A is soldered with each first polar pad 101 of the first cell piece 100A in one-to-one correspondence, the second soldering portion of each structural solder strip contained in the second interconnection piece 200B is soldered with the second polar pad 102 of the second cell piece 100B in one-to-one correspondence, and the junction bar 300 is respectively soldered with the second soldering portion 221B of each structural solder strip contained in the first interconnection piece 200A and the first soldering portion 221A of each structural solder strip contained in the second interconnection piece 200B.

FIG. 8 is a schematic structural diagram of a flexible insulating substrate provided by the embodiments of the present disclosure. As shown in FIG. 8, the flexible insulating substrate 210 is internally provided with a conducting layer 212. As shown in FIG. 7A and FIG. 7B, the connecting portions 221 of the structural solder strips 220 are electrically connected through the conducting layer 212. It should be understood that the conducting layer 212 in FIG. 8 is partially exposed, but in actual situation, the exposed conducting layer 212 in FIG. 8 is generally embedded in the flexible insulating substrate 210 to reduce unnecessary pollution and loss.

As shown in FIG. 8, the conducting layer 212 may be a conducting ribbon or a conducting particle layer composed of metal particles in contact with each other. The conducting ribbon may be one or more of a copper ribbon, a silver ribbon, an aluminum ribbon, or the like. The conducting particle layer may include one or more of copper particles, silver particles, aluminum particles, or the like, which are mutually contacted with each other. In practical application, conductive particle slurry may be formed on one side of the flexible insulating layer, and a solvent contained in the flexible insulating substrate 210 may be removed (e.g., dried at low temperature) to form the conducting particle layer without damaging the flexible insulating substrate 210. Then, another flexible insulating substrate 210 is covered on a surface of the flexible insulating layer where the conducting particle layer is formed, so that the conducting particle layer is formed in the flexible insulating substrate.

Based on the above structure, as shown in FIG. 7A, FIG. 7B and FIG. 8, when the conducting layer 212 electrically connects the connecting portions 221 included in each structural solder strip 220, the conducting layer 212 may be used as a lateral conducting channel. When the first soldering portion 221A of one structural solder strip 220 of the plurality of structural solder strips 220 has poor soldering with the first polar pad, the structural solder strip 220 is partially failed as a vertical conducting channel, but the structural solder strip 220 may also conduct the current to other well-soldered structural solder strips 220 by using the conducting layer, thus avoiding a problem of cell efficiency reduction when the vertical conducting channel is partially failed, thus improving the connection reliability of the interconnection piece.

FIG. 9A illustrates a schematic structural diagram of an example interconnection piece in the embodiments of the present disclosure. FIG. 9B illustrates a schematic structural diagram of another example interconnection piece in the embodiments of the present disclosure. As shown in FIG. 9A and FIG. 9B, a surface of the connecting portion 221 of each structural solder strip 220 away from the flexible insulating substrate 210 is exposed. In this case, the plurality of structural solder strips 220 may be placed on the surface of the flexible insulating substrate 210, and the plurality of structural solder strips 220 may be pressed on the flexible insulating substrate 210 under pressure.

As shown in FIG. 9A and FIG. 9B, when the flexible insulating substrate 210 is internally provided with the conducting layer 212, the flexible insulating substrate 210 includes two flexible insulating layers 211 and the conducting layer 212 located between the two flexible insulating substrates 211. In this case, when the plurality of structural solder strips 220 are pressed on one side of the flexible insulating substrate 210 by a hot pressing process, the pressure can be controlled, so that a bottom of the connecting portion 221 contained in the structural solder strip 220 contacts with the conducting layer 212.

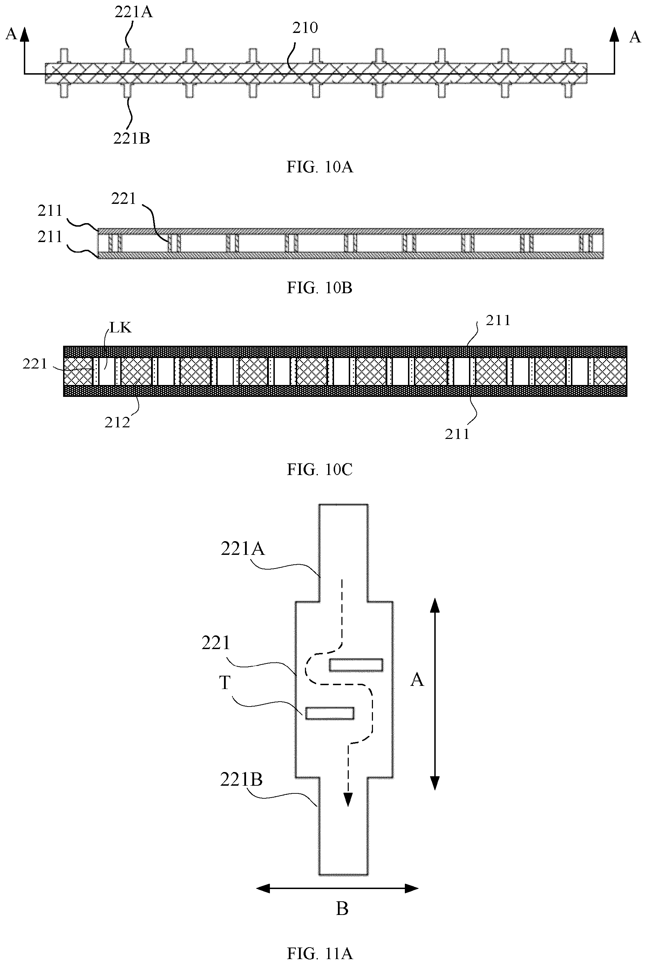

FIG. 10A illustrates a schematic structural diagram of another example interconnection piece in the embodiments of the present disclosure. FIG. 10B illustrates a sectional view of the interconnection piece shown in FIG. 10A in an A-A direction. As shown in FIG. 10A and FIG. 10B, when the connecting portion 221 of each structural solder strip 220 is embedded in the flexible insulating substrate 210, at least a part of the connecting portion 221 of each structural solder strip 220 is wrapped in the flexible insulating substrate 210. The first soldering portion 221A and the second soldering portion 221B extend out of the flexible insulating substrate 210 in opposite directions. In this case, the interconnection piece shown in FIG. 10A is a sandwich structure, and the flexible insulating substrate 210 may be used to further fix the structural solder strip 220, which not only further reduces or eliminates possible displacement of the structural solder strip 220 in the soldering process, but also eliminates a possibility of connection failure between the structural solder strip 220 and the flexible insulating substrate 210 when one soldering portion of the structural solder strip 220 is stressed and warped, thus ensuring connection stability between the structural solder strip 220 and the flexible insulating substrate 210.

FIG. 10C illustrates another sectional view of the interconnection piece shown in FIG. 10A in the A-A direction. As shown in FIG. 10C, when the plurality of structural solder strips are pressed between two flexible insulating layers 211 by a hot pressing process, the conducting layer 212 is embedded in the flexible insulating substrate 210. In this case, the conducting layer 212 may be formed in one flexible insulating layer 211, and then the structural solder strip 220 shown in FIG. 7A or FIG. 7B may be formed on a surface of the flexible insulating layer 211 where the conducting layer 212 is formed. Based on this, another flexible insulating layer 211 is pressed on a surface of the flexible insulating layer 211 where the conducting particle layer 212 is formed. In this case, the connecting portion 221 of each structural solder strip 220 is at least partially wrapped between the two flexible insulating layers 211, thus ensuring that the connecting portion 221 of each structural solder strip 220 directly contacts the conducting layer 212.

In an optional way, as shown in FIG. 7A and FIG. 7B, the connecting portion 221 above is provided with a hollow structure LK for releasing stress. In addition to the hollow structure LK, other areas of the connecting portion 221 are all solid structures. In this case, the hollow structure LK may be used to release a stress caused by a soldering process, a laminating process and a difference between outdoor high and low temperatures, thereby reducing a bending deformation degree of the back-contact cell and improving soldering stability and long-term use stability.

The hollow structure LK shown in FIG. 7A and FIG. 7B may include at least one through hole T. A pattern of each through hole T is a closed pattern. In this case, the closed pattern here refers to that an outline pattern of the hollow structure LK is closed. In this case, an edge outline of the connecting portion 221 is complete, which can ensure that the structural solder strip 220 has good strength. The pattern of each through hole is a polygonal pattern, a circular pattern, an elliptical pattern or a special-shaped pattern. The polygonal pattern may be a triangle, a rectangle, a square, or the like. For example, a shape of the through hole is rectangular, and a length of the through hole may be 1 mm to 10 mm.

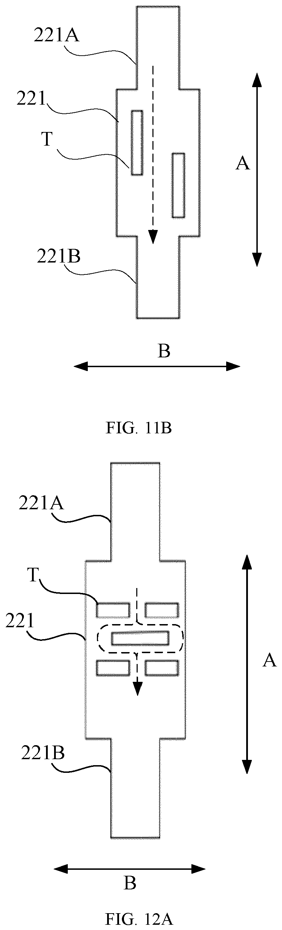

FIG. 11A to 13A are schematic diagrams showing three types of distributions of a plurality of rows of through holes distributed along a first direction in the embodiments of the present disclosure. FIG. 11B to 13B are schematic diagrams showing three types of distributions of a plurality of rows of through holes distributed along a second direction in the embodiments of the present disclosure. As shown in FIG. 11A to FIG. 13A and FIG. 11B to FIG. 13B, the hollow structure LK shown in FIG. 7A and FIG. 7B includes m rows of through holes, and m is an integer greater than or equal to 1. Each row of through holes includes at least one through hole. The first row of through holes and the m-th row of through holes are formed in the connecting portion 221 along any direction parallel to the connecting portion 221. For example, when m is an integer greater than or equal to 2, the first row of through holes to the m-th row of through holes are distributed along a distribution direction (first direction A) of the first soldering portion 221A and the second soldering portion 221B. For another example, when m is an integer greater than or equal to 2, the first row of through holes to the m-th row of through holes are distributed along a distribution direction (second direction B) vertical to the first soldering portion 221A and the second soldering portion 221B.

When the first row of through holes to the m-th row of through holes are distributed along the first direction A as shown in FIG. 11A to FIG. 13A, the through holes T are slit-shaped through holes or rectangular through holes, and a distribution mode of two adjacent rows of through holes T may be appropriately adjusted to ensure that there is a shorter circuit path between the first soldering portion 221A and the second soldering portion 221B when ensuring that the strength and stress relieving ability are appropriate.

When the first row of through holes to the m-th row of through holes are distributed along the second direction B as shown in FIG. 11B to FIG. 13B, the through holes T are slit-shaped through holes or rectangular through holes. When a length direction of the through hole T is from the distribution direction vertical to the first soldering portion 221A and the second soldering portion 221B, an interval between two rows of through holes may be adjusted, so that currents of the first soldering portion 221A and the second soldering portion 221B can be transmitted to another soldering portion through the connecting portion 221 as linearly as possible, thereby reducing a current loss.

Exemplary, two adjacent rows of through holes are distributed in a staggered way. At this time, the m rows of through holes in the connecting portion can uniformly release the stress generated by the structural solder strips, and further reduce the deformation degree of the back-contact cell. Certainly, the distribution form of each row of through holes may also be adjusted to balance a structural strength and a stress release capacity of the connecting portion. For example, as shown in FIG. 11A and FIG. 11B, the connecting portion 221 contained in the structural solder strip 220 is provided with two rows of slit-type through holes distributed in a staggered way, and each row of slit-type through holes contains one slit-type through hole. The two rows of slit-type through holes may either be distributed along the first direction A shown in FIG. 11A, or distributed along the second direction B shown in FIG. 11B.

As shown in FIG. 11A, when two rows of through holes are distributed according to the first direction A, ends of the first row of through holes and ends of the second row of through holes are staggered, so that a current conducted by the first soldering portion 221A and the second soldering portion 221B can be conducted in the connecting portion along a dotted line direction shown in FIG. 11A.

As shown in FIG. 11B, when two rows of through holes are distributed according to the second direction B, each row of through holes is a slit-type through hole. A length direction of the slit-type through hole is the same as the first direction A. In this case, a distance between two adjacent rows of slit-type through holes may be adjusted, which provides a hardware foundation for the first soldering portion 221A and the second soldering portion 221B to conduct the current in a dotted line direction shown in FIG. 11B.

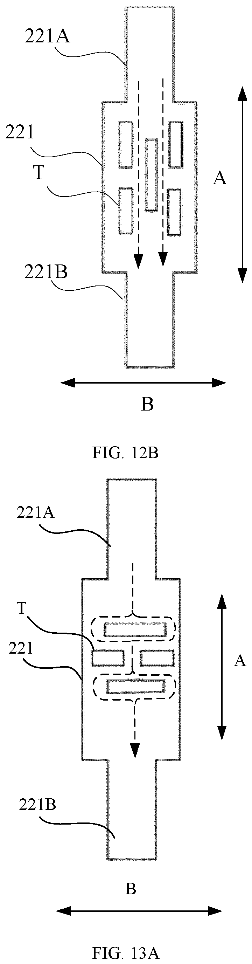

For example, as shown in FIG. 12A and FIG. 12B, m is an integer greater than or equal to 3. The quantity of through holes contained in the first row of through holes and the quantity of through holes contained in the m-th row of through holes are both greater than or equal to 2. In this case, along the distribution direction of the first row of through holes to the m-th row of through holes, the quantity of through holes included in each row of through holes first decreases and then increases. Along the distribution direction of the first row of through holes to the m-th row of through holes, if the length of each row of through holes along the row direction decreases first and then increases, a structural strength of the connecting portion 221 increases first and then decreases, and a stress of the connecting portion 221 sequentially decreases first and then sequentially increases along the distribution direction of the first row of through holes to the m-th row of through holes. Based on this, a distribution manner of the through holes in the connecting portion 221 may be used to adjust strength and a stress release capacity of each area of the connecting portion 221, so that the strength and the stress release capacity of the connecting portion 221 achieve coordination.

As shown in FIG. 12A and FIG. 12B, when the first row of through holes and the m-th row of through holes are formed in the connecting portion 221 along the distribution direction of the two soldering portions, if the quantity of through holes contained in each row of through holes decreases first and then increases, and a distance between the front and rear ends of each row of through holes and an edge of the connecting portion 221 decreases first and then increases, the current conducted between the first soldering portion 221A and the second soldering portion 221B is as short as possible in a current path of the connecting portion 221.

For example, as shown in FIG. 12A and FIG. 12B, the connecting portion 221 contained in the structural solder strip 220 is provided with three rows of slit-type through holes. The first row of through holes and the third row of through holes both include two slit-type through holes, and the second row of through holes includes one slit-type through hole. One slit-type through hole included in the second row of through holes is longer than the slit-type through hole included in the first row of through holes, but does not exceed ends of the first row of through holes and the third row of through holes. In this case, the first row of through holes and the third row of through holes contain a large quantity of slit-type through holes while the second row of through holes contain a small quantity of slit-type through holes, which can make the strain relief ability of both ends of the connecting portion 221 higher, but the strength is weaker, and the strain relief ability of a middle position is poor, but the strength is higher. Therefore, the distribution manner of the m rows of through holes can balance the strain relief ability and strength of each area of the connecting portion 221, so that the structural solder strip has high strain relief ability while ensuring the strength.

As shown in FIG. 12A, when three rows of through holes are distributed according to the first direction A, ends of the second row of through holes do not exceed ends of the first row of through holes and the third row of through holes, so that the current conducted by the first soldering portion 221A and the second soldering portion 221B is conducted in a current path of the connecting portion 221 in a dotted line shown in FIG. 12A.

As shown in FIG. 12B, when the three rows of through holes are distributed along the second direction B, each row of through holes is a slit-type through hole, and a length direction of the slit-type through hole is distributed along the first direction. In this case, a distance between two adjacent rows of slit-type through holes may be adjusted, the current path in the connecting portion 221 of the current conducted by the first soldering portion 221A and the second soldering portion 221B is the dotted line shown in FIG. 12B.

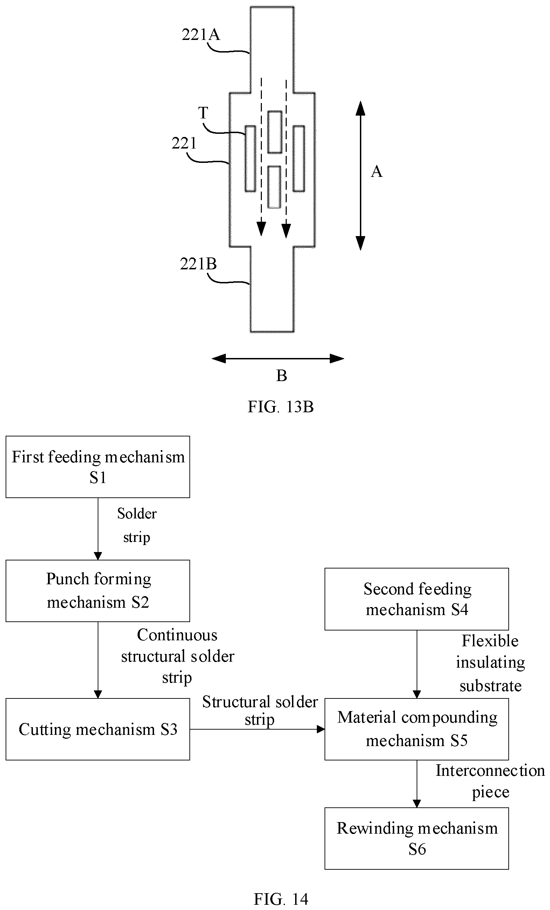

Illustratively, as shown in FIG. 13A A and FIG. 13B, when m is an integer greater than or equal to 3, a quantity of through holes contained in the first row of through holes and a quantity of through holes contained in the m-th row of through holes are both greater than or equal to 1. Along the distribution direction of the first row of through holes to the m-th row of through holes, the quantity of through holes included in each row of through holes first increases and then decreases.

As shown in FIG. 13A and FIG. 13B, along the distribution direction of the first row of through holes to the m-th row of through holes, if the length of each row of through holes along the row direction increases first and then decreases, a structural strength of the connecting portion 221 decreases first and then increases, and a stress of the connecting portion 221 sequentially increases first and then sequentially decreases along the distribution direction of the first row of through holes to the m-th row of through holes. Based on this, a distribution manner of the through holes in the connecting portion 221 may be used to adjust a strength and a stress release capacity of each area of the connecting portion 221, so that the strength and the stress release capacity of the connecting portion 221 achieve coordination.

For example, as shown in FIG. 13A and FIG. 13B, the connecting portion 221 contained in the structural solder strip 220 is provided with three rows of slit-type through holes. The first row of through holes and the third row of through holes both include one slit-type through holes, and the second row of through holes includes two slit-type through holes. One slit-type through hole included in the first row of through holes is longer than the slit-type through hole included in the second row of through holes, but ends of the first row of through holes and the third rows of through holes do not exceed ends of the second row of through holes. In this case, the first row of through holes and the third row of through holes contain a small quantity of slit-type through holes while the second row of through holes contain a large quantity of slit-type through holes, which can make the strength of both ends of the connecting portion 221 higher, but the strain relief ability is weaker, and the strain relief ability of a middle position is higher, but the strength is weaker. Therefore, the distribution manner of the m rows of through holes T can balance the strain relief ability and strength of each area of the connecting portion 221, so that the structural solder strip 220 has high strain relief ability while ensuring the strength.

As shown in FIG. 13A, when three rows of through holes are distributed according to the first direction A, ends of the first row of through holes and the third row of through holes do not exceed the second row of through holes, so that the current conducted by the first soldering portion 221A and the second soldering portion 221B may flow in connecting portion 221 in a dotted line direction shown in FIG. 13A.

As shown in FIG. 13B, when the three rows of through holes are distributed along the second direction B, each row of through holes is a slit-type through hole, and a length direction of the slit-type through hole is distributed along the first direction A. In this case, a distance between two adjacent rows of slit-type through holes may be adjusted, such that the current conducted by the first soldering portion 221A and the second soldering portion 221B may flow in connecting portion 221 in a dotted line direction shown in FIG. 13B.

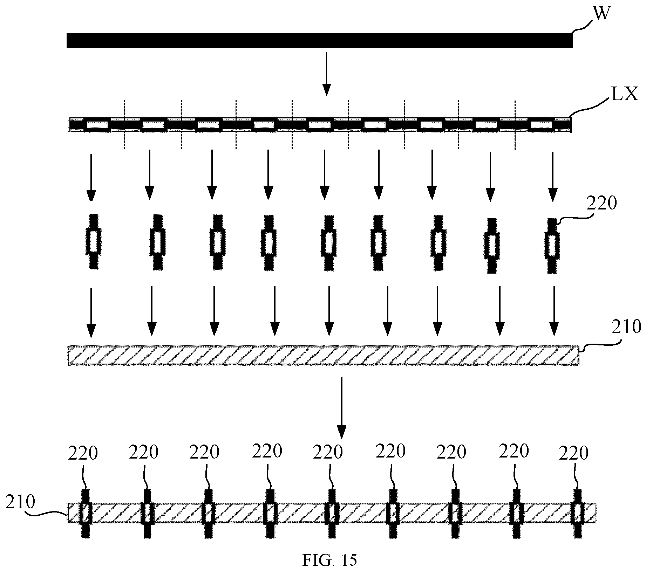

FIG. 14 illustrates a schematic structural diagram of a manufacturing device for an interconnection piece provided by the embodiments of the present disclosure. The manufacturing device for the interconnection piece includes a first feeding mechanism S1, a punch forming mechanism S2, a cutting mechanism S3, a second feeding mechanism S4, a material compounding mechanism S5 and a rewinding mechanism S6. The punch forming mechanism S2 is provided with a punched head and a forming die. The forming die includes an upper punch die and a lower punch die. The upper punch die and the lower punch die have structural solder strip forming portions corresponding to the structural solder strip 220. The structural diagram of the structural solder strip forming portion may refer to the structure of the structural solder strip mentioned above, and specifically includes two soldering forming portions and a connection forming portion located between the two soldering forming portions. The connection forming portion is respectively connected to the two soldering forming portions, and the connection forming portion is provided with a structure for forming a hollow structure on the solder strip. The manufacturing process of the interconnection piece provided by the embodiments of the present disclosure will be described below with reference to the structural flow diagram of the manufacturing method of the interconnection piece in each stage shown in FIG. 15.

As shown in FIG. 14 and FIG. 15, the above-mentioned first feeding mechanism S1 may supply the solder strip W shown in FIG. 14 to the punch forming mechanism. The punched head included in the punch forming mechanism S2 controls closing and demoulding of the lower punch die and the upper punch die, and punch the solder strip W to obtain the solder strip LX of the connecting structure as shown in FIG. 14. The connection structure solder strip LX is an integrated structure formed by the plurality of structural solder strips 220 described above. One soldering portions contained in two adjacent structural solder strips 220 are connected. The cutting mechanism S3 is used for cutting the soldering portions of the two adjacent structural solder strips 220 connected together to form the plurality of independent structural solder strips 220. The second feeding mechanism S4 may provide the flexible insulating substrate 210 to the material compounding mechanism S5. The material compounding mechanism S5 may be a hot-pressing roller mechanism, and the flexible insulating substrate 210 can be hot-pressed at 50°C to120°C (for example, 100°C) for 5 seconds to 30 seconds, and the plurality of structural solder strips 220 may be hot-pressed onto the flexible insulating substrate to form the interconnection pieces. The rewinding mechanism winds the interconnection pieces together.

It should be noted that when the interconnection piece adopts a sandwich structure, the second feeding mechanism S4 may include two feeding rollers, both of which are used to provide the flexible insulating substrate 210 to the material compounding mechanism S5. The material compounding mechanism S5 can not only realize the compounding of a two-layer structure, but also the compounding of a three-layer structure. For example, the plurality of structural solder strips are spaced along a length direction of the flexible insulating substrate, and another flexible insulating substrate is formed on the surface of the flexible insulating substrate distributed with the structural solder strip by hot pressing, thus forming the interconnection piece of a sandwich structure.

In the description of the above exemplary embodiments, the specific features, structures, materials or characteristics may be combined in any one or more embodiments or examples in a suitable manner.

The foregoing descriptions are merely detailed embodiments of the present disclosure, but the protection scope of the present disclosure is not limited thereto. Any changes or substitutions that can be easily thought of by those familiar with the technical field within the technical scope disclosed in the present disclosure should be covered by the protection scope of the present disclosure. Therefore, the protection scope of the present disclosure should be subjected to the protection scope of the claims.

The above-described apparatus embodiments are merely illustrative, wherein the units that are described as separate components may or may not be physically separate, and the components that are displayed as units may or may not be physical units; in other words, they may be located at the same one location, and may also be distributed to a plurality of network units. Part or all modules therein may be selected according to actual needs to realize the objective of achieving the technical solution of the embodiment. A person skilled in the art can understand and implement the technical solutions without paying creative work.

The "one embodiment", "an embodiment" or "one or more embodiments" as used herein means that particular features, structures or characteristics described with reference to an embodiment are included in at least one embodiment of the present disclosure. Moreover, it should be noted that here an example using the wording "in an embodiment" does not necessarily refer to the same one embodiment.

Many details are discussed in the specification provided herein. However, it can be understood that the embodiments of the present disclosure may be implemented without those concrete details. In some of the embodiments, well-known processes, structures and techniques are not described in detail, so as not to affect the understanding of the description.

In the claims, any reference signs between parentheses should not be construed as limiting the claims. The word "include" does not exclude elements or steps that are not listed in the claims. The word "a" or "an" preceding an element does not exclude the existing of a plurality of such elements. The present disclosure may be implemented by means of hardware including several different elements and by means of a properly programmed computer. In unit claims that list several devices, some of those apparatuses may be embodied by the same item of hardware. The words first, second, third and so on do not denote any order. Those words may be interpreted as names.

Finally, it should be noted that the above embodiments are merely intended to explain the technical solutions of the present disclosure, and not to limit them. Although the present disclosure is explained in detail by referring to the above embodiments, a person skilled in the art should understand that he can still modify the technical solutions set forth by the above embodiments, or make equivalent substitutions to part of the technical features of them. However, those modifications or substitutions do not make the essence of the corresponding technical solutions depart from the spirit and scope of the technical solutions of the embodiments of the present disclosure.

## Claims

1. An interconnection piece applied to back-contact cell interconnection, **characterized in that** the interconnection piece comprises: a flexible insulating substrate and a plurality of structural solder strips arranged on the flexible insulating substrate at intervals; each structural solder strip is provided with two soldering portions and a connecting portion located between the two soldering portions, and the connecting portion is respectively connected to the two soldering portions; and at least a part of the connecting portion is located on the flexible insulating substrate, and the two soldering portions extend out of the flexible insulating substrate.

2. The interconnection piece according to claim 1, wherein the connecting portion is provided with a hollow structure for releasing stress.

3. The interconnection piece according to claim 2, wherein the hollow structure comprises at least one through hole;
wherein a pattern of each through hole is a closed pattern; and/or
the pattern of each through hole is a polygonal pattern, a circular pattern, an elliptical pattern or a special-shaped pattern.

4. The interconnection piece according to claim 2, wherein the hollow structure comprises m rows of through holes, and m is an integer greater than or equal to 1; and each row of through holes comprises at least one through hole, and the first row of through holes and the m-th row of through holes are formed in the connecting portion along any direction parallel to the connecting portion.

5. The interconnection piece according to claim 4, wherein two adjacent rows of through holes are distributed in a staggered manner;
wherein m is an integer greater than or equal to 3, and a quantity of through holes comprised in the first row of through holes and a quantity of through holes in the m-th row of through holes are both greater than or equal to 2; and along a distribution direction of the first row of through holes to the m-th row of through holes, a quantity of through holes comprised in each row of through holes first decreases and then increases; and/or
m is the integer greater than or equal to 3, and the quantity of through holes comprised in the first row of through holes and the quantity of the m-th row of through holes are both greater than or equal to 1; and along the distribution direction of the first row of through holes to the m-th row of through holes, the quantity of through holes comprised in each row of through holes first increases and then decreases.

6. The interconnection piece according to any one of claims 1 to 5, wherein central axes of the two soldering portions are collinear; and/or
a width of each soldering portion is smaller than a maximum width of the connecting portion, and each soldering portion is connected to the connecting portion in an arc transition mode.

7. The interconnection piece according to any one of claims 1 to 5, wherein the flexible insulating substrate is a light-shielding flexible insulating substrate; or
at least one surface of the flexible insulating substrate is partially or completely provided with a shielding coating; or
the flexible insulating substrate is a single-sided adhesive tape provided with a release layer or a double-sided adhesive tape provided with a release layer.

8. The interconnection piece according to any one of claims 1 to 5, wherein a surface of the connecting portion of each structural solder strip away from the flexible insulating substrate is exposed; or
at least a part of the connecting portion of each structural solder strip is wrapped in the flexible insulating substrate; or
each structural solder strip is thermally pressed or bonded on the flexible insulating substrate.

9. The interconnection piece according to any one of claims 1 to 5, wherein the flexible insulating substrate is internally provided with a conducting layer, and the connecting portions of each structural solder strip are electrically connected through the conducting layer;
wherein the conducting layer is a conducting ribbon or a conducting particle layer composed of metal particles in contact with each other.

10. A solar cell assembly, comprising at least two cell pieces and a plurality of interconnection pieces used for interconnecting the cell pieces, each interconnection piece being the interconnection piece according to claim 1;
wherein a back of each cell piece is provided with two types of polar pads, and each polar pad contained in each type of polar pads is soldered with one soldering portion of the corresponding structural solder strip contained in the corresponding interconnection piece.

11. The solar cell assembly according to claim 10, wherein a gap is disposed between the two adjacent cell pieces, and the gap contains the corresponding interconnection piece, and a back of each cell piece is provided with two types of polar pads close to an edge of the cell piece, the different polar pads of the two adjacent cell pieces are close to the same gap, and the interconnection piece corresponding to the different polar pads of the two adjacent cell pieces is the same interconnection piece.

12. The solar cell assembly according to claim 10, wherein the solar cell assembly further comprises at least one junction bar; and each junction bar is soldered with one soldering portion contained in the plurality of structural solder strips of the corresponding interconnection piece.

13. The solar cell assembly according to claim 12, wherein when the junction bar is located between the two adjacent cell pieces, the interconnection pieces corresponding to different polar pads of the two adjacent cell pieces are different interconnection pieces, and the interconnection pieces corresponding to the different polar pads of the two adjacent cell pieces share one junction bar.

14. The solar cell assembly according to any one of claims 10 to 13, wherein the solar cell assembly further comprises a visual shielding layer located between the two adjacent cell pieces, and the visual shielding layer is located on a surface of at least one of the interconnection pieces facing a front of the cell piece.
